# EUROPEAN PATENT APPLICATION

(11) **EP 3 416 464 A1**
(43) Date of publication of application: **19.12.2018**
(21) Application number: 17382367.5
(22) Date of filing: 14.06.2017
(51) Int. Cl.: H05K 3/10

(54) **METHOD FOR MANUFACTURING AN ELECTRONIC ASSEMBLY AND LIGHTING DEVICE**

(71) Applicant: Valeo Iluminacion, 23600 Martos (ES)
(72) Inventor: TEBA, Daniel, 23600 Martos (ES); GUTIERREZ, Daniel-Jesus, 23600 Martos (ES)

(57) **Abstract**

The invention provides a method for manufacturing an electronic assembly (1). This method comprising at least three steps. The first step includes the provision of a plastics substrate (2) and the second step includes the deposition of a conductive track (3) on the plastics substrate (2). Finally, the third step of this method includes applying a pressure or at least one hit on the conductive track (3) so that the conductive track (3) becomes at least partially embedded in the plastics substrate (2).

## Description

### TECHNICAL FIELD

This invention is related to the field of the manufacturing of electronic assemblies for automotive lighting devices, and more specifically to the positioning of cables or wires on a plastics substrate.

### STATE OF THE ART

Electronic circuits require of high quality conductive tracks. Printed Circuit Boards (PCBs) are usually interconnected by expensive flexible boards. To reduce high manufacturing costs, other alternatives are being proposed. The use of metal powder to directly deposit conductive tracks on the circuit boards is a good alternative, but has some problems regarding the quality of the electric power conduction. Powder metal will never reach the electrical conductivity of malleable solid metals. But these solid metals require high thickness and coatings to isolate one cable from another one.

### DESCRIPTION OF THE INVENTION

The invention provides a solution for this problem by means of a method for manufacturing an electronic assembly according to claim 1 and a lighting device according to claim 14. Preferred embodiments of the invention are defined in dependent claims.

In an inventive aspect, the invention provides a method for manufacturing an electronic assembly, the method comprising the steps of
providing a plastics substrate;
depositing a conductive track on the plastics substrate; and
applying a pressure or at least one hit on the conductive track so that the conductive track becomes at least partially embedded in the plastics substrate.

Advantageously, this method allows the deposition of a conductive track on a plastics substrate in an easy and durable way.

In some particular embodiments, the step of applying a pressure or a hit on the conductive track further comprises applying heat on the conductive track.

The application of heat improves the embedding of the conductive track into the plastics substrate, since the mechanical properties of the plastics substrate depend on its temperature.

In some particular embodiments, the conductive track is a bare wire.

These embodiments make it possible the use of an automated wire depositing machine, which would only have to follow simple instructions to lay out the bare wires on the plastics substrate, thus saving time and cost.

In some particular embodiments, the plastics substrate comprises a positioner and the conductive track is deposited in contact with the positioner.

This positioner is not necessarily dug into the plastics substrate, the only condition is that the channel is a surface such that a cable placed in this channel is in stable equilibrium. As a consequence, any element that may confine a portion of the conductive track is valid for this purpose.

In some particular embodiments,
the positioner comprises a channel; and
after applying a pressure or at least one hit on the conductive track, the conductive track is at least partially encircled by the channel.

One of the most advantageous embodiments of a positioner is a channel. The channel holds the conductive track in a stable position, and is also advantageous when receiving pressure, deforming to reinforce de embedment of the conductive track into the plastics substrate.

In some particular embodiments, the channel comprises a cross section which has part of a circumference.

Since a great amount of the conductive tracks have circular shape, a circumference suits very well with the purpose of providing a stable position to the conductive track before applying pressure.

In some particular embodiments, the conductive track has a substantially circular cross section with a first diameter, and the channel has a cross section that comprises two straight portions and a curved portion.

The addition of two straight portions has several advantages: on one hand, it contributes to the stable position of the conductive track and, on the other hand, it provides an amount of plastics to improve the embedment of the conductive track into the plastics substrate after the application of pressure.

In some particular embodiments, the length of the straight portions is greater than the first diameter, preferably greater than two times the first diameter and preferably greater than three times the first diameter.

These particular embodiments provide concrete examples which are acceptable for the aforementioned aims.

In some particular embodiments, the straight portions form an angle between 0 and 60 degrees with each other, preferable between 5 and 20 degrees or between 20 and 40 degrees or between 40 and 60 degrees.

These values have proven to provide a good performance of the method.

In some particular embodiments, the minimum distance between the straight portions is lower than 1.5 times the first diameter.

The fact that the minimum distance between the straight portions is lower than this value provides a better confinement for the conductive track.

In some particular embodiments, the channel stands out from the plastics substrate.

These embodiments are advantageous because an outstanding channel further provides a guide for the conductive track to be installed, and the outstanding portion is useful when applying pressure, since it may cover the conductive track and avoid its displacement.

In some particular embodiments, the channel has a cross section which comprises more than a half of a circumference.

Another option, which ensures a better guidance for the conductive track, is providing more than a half of a circumference. The conductive track is therefore fitted into the channel, and the embedding operation is even easier.

In some particular embodiments, the plastics substrate comprises more than one channel, thus providing more than one embedment point for the conductive track to the plastics substrate.

The channel may be a single channel or may be divided into several channel portions. The fact of providing more than one channel portion improves the step of the conductive track deposition, since the conductive track only needs to be adjusted in concrete channel portions instead of being adjusted along the complete section of a channel.

In a further inventive aspect, the invention provides a lighting device comprising an electronic assembly manufactured by a method according to any of the preceding claims.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 shows a plastics substrate which takes part in a method of manufacturing an electronic assembly according to the invention.
Figures 2a to 2e show different cross sections of these channel or channel portions.
Figures 3a to 3c shows the steps of a method for manufacturing an electronic assembly according to the invention.
Figure 4 shows a lighting device comprising an electronic assembly manufactured by a method as shown above.

### DETAILED DESCRIPTION OF THE INVENTION

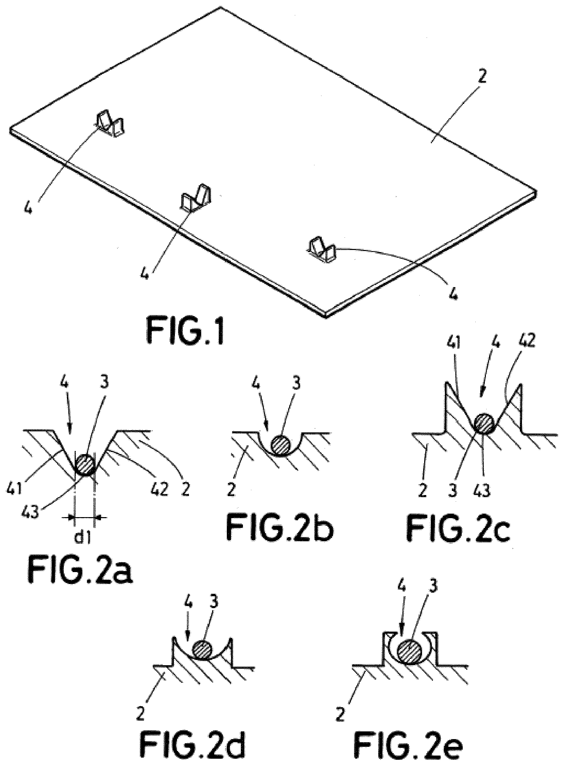

Figure 1 shows a plastics substrate 2 which takes part in a method of manufacturing an electronic assembly according to the invention. This plastics substrate 2 comprises a channel 4, which is included in the plastics substrate 2, e.g., by moulding. In the embodiment shown in this figure 1, part of this channel 4 is dug into the plastics substrate 2 and part of the channel 4 stands out from the plastics substrate. However, in other embodiments it may just stand out from the plastics substrate, in such a way that it provides positioning for the cable to be in stable equilibrium.

In the embodiment shown in this figure, the channel 4 is not a continuous channel that prepares a path for the whole conductive track which is intended to be deposited in the channel, but is provided as channel portions, in such a way that only some portions of the conductive track are intended to be placed on a channel portion 4, and the rest of the conductive track is just laid on the plastics substrate 2. However, in different embodiments, a complete channel may be provided.

Figures 2a to 2e show different cross sections of these channel or channel portions.

Figure 2a shows a cross section of the channel 4 comprised in an embodiment of the invention. This channel portion is dug into the plastics substrate and comprises two straight portions 41, 42 and a curved portion 43. The curved portion 43 comprises part of a circumference and the straight portions have a length which is greater than two times the diameter of the cross section of the conductive track 3, called first diameter d1.

Figure 2b shows a cross section of the channel comprised in another embodiment of the invention. This channel portion 4 is dug into the plastics substrate 2 and comprises part of a circumference, without the presence of straight portions.

Figure 2c shows a cross section of the channel comprised in another embodiment of the invention. This channel portion 4 stands out from the plastics substrate 2 and comprises two straight portions 41, 42 and a curved portion 43. The curved portion 43 comprises part of a circumference and the straight portions 41, 42 have a length which is greater than two times the first diameter d1. The minimum distance between the straight portions is 1.25 times the first diameter.

Figure 2d shows a cross section of the channel comprised in another embodiment of the invention. This channel portion 4 stands out from the plastics substrate 2 and comprises part of a circumference, without the presence of straight portions.

Figure 2e shows a cross section of the channel comprised in another embodiment of the invention. This channel portion 4 stands out from the plastics substrate 2 and comprises more than a half of a circumference.

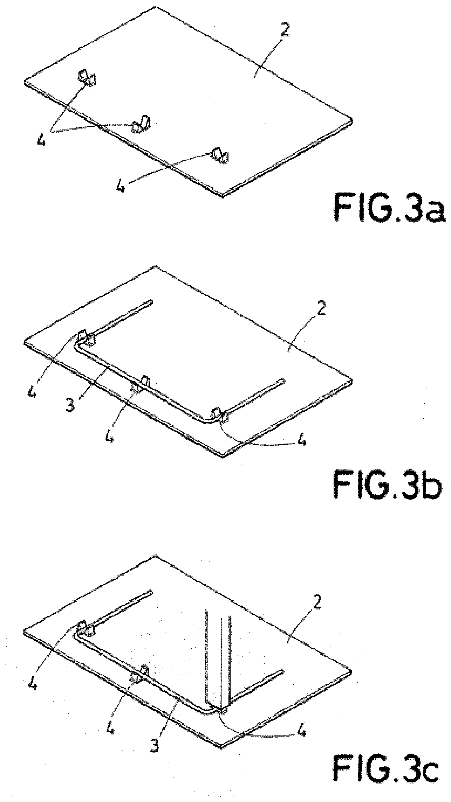

Figures 3a to 3c shows the steps of a method for manufacturing an electronic assembly according to the invention.

Figure 3a shows a first step, comprising the provision of a plastics substrate 2 comprising a channel 4. Any of the plastics substrates shown in the abovementioned figures and any other plastics substrate comprising at least a channel portion, as understood in this document, is suitable for this step.

Figure 3b shows a second step of this method, comprising the deposition of a conductive track 3 on the plastics substrate, in such a way that at least part of this conductive track 3 is deposited on this channel portion 4. In this case, part of the conductive track 3, which is a bare wire, is deposited on the channel portion 4. Other conductive tracks may be used in different embodiments of this method.

Figure 3c shows a third step of this method, which comprises applying pressure and heat on this portion of the conductive track 3, in such a way that the conductive track is encircled by the channel.

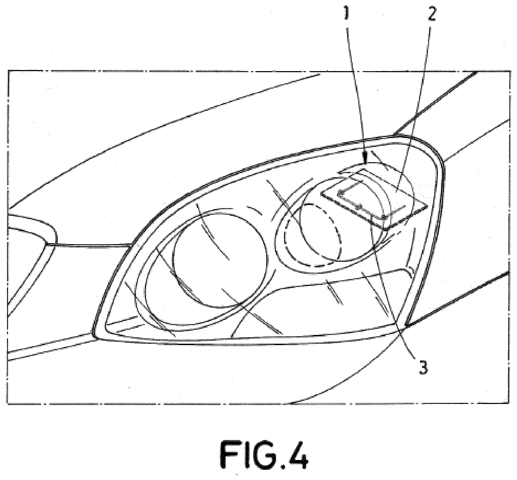

Figure 4 shows a lighting device 10 comprising an electronic assembly 1 manufactured by a method as shown above.

## Claims

1. Method for manufacturing an electronic assembly (1), the method comprising the steps of
providing a plastics substrate (2);
depositing a conductive track (3) on the plastics substrate (2); and
applying a pressure or at least one hit on the conductive track (3) so that the conductive track (3) becomes at least partially embedded in the plastics substrate (2).

2. Method according to claim 1, wherein the step of applying a pressure or a hit on the conductive track (3) further comprises applying heat on the conductive track (3).

3. Method according to any of the preceding claims, wherein the conductive track (3) is a bare wire.

4. Method according to any of the preceding claims, wherein
the plastics substrate (2) comprises a positioner;
the conductive track (3) is deposited in contact with the positioner.

5. Method according to claim 4, wherein
the positioner comprises a channel (4); and
after applying a pressure or at least one hit on the conductive track (3), the conductive track (3) is at least partially encircled by the channel (4).

6. Method according to claim 5, wherein the channel (4) comprises a cross section which has part of a circumference.

7. Method according to any of claims 5 or 6, wherein the conductive track (3) has a substantially circular cross section with a first diameter (d1), and the channel (4) has a cross section that comprises two straight portions (41, 42) and a curved portion (43).

8. Method according to any of claims 6 or 7, wherein the length of the straight portions (41, 42) is greater than the first diameter (d1), preferably greater than two times the first diameter (d1) and preferably greater than three times the first diameter (d1).

9. Method according to any of claims 6 to 8, wherein the straight portions (41, 42) form an angle between 0 and 60 degrees with each other, preferable between 5 and 20 degrees or between 20 and 40 degrees or between 40 and 60 degrees.

10. Method according to any of claims 6 to 9, wherein the minimum distance between the straight portions (41, 42) is lower than 1.5 times the first diameter (d1).

11. Method according to any of claims 5 to 10, wherein the channel (4) stands out from the plastics substrate (2).

12. Method according to claim 11, wherein the channel (4) has a cross section which comprises more than a half of a circumference.

13. Method according to any of the preceding claims, wherein the plastics substrate (2) comprises more than one channel (4), thus providing more than one embedment point for the conductive track (3) to the plastics substrate (2).

14. Lighting device (10) comprising an electronic assembly (1) manufactured by a method according to any of the preceding claims.
